# EUROPÄISCHE PATENTANMELDUNG

(11) **EP 3 112 597 A1**
(43) Veröffentlichungstag der Anmeldung: **04.01.2017**
(21) Anmeldenummer: 15175008.0
(22) Anmeldetag: 02.07.2015
(51) Int. Cl.: F01D 5/28, C04B 35/00

(54) **TEMPERATUR BESTÄNDIGE TURBINENSCHAUFEL MIT OXIDKERAMIK BESCHICHTUNG**

(71) Anmelder: Airbus Defence and Space GmbH, 85521 Ottobrunn (DE)
(72) Erfinder: STEINWANDEL, Jürgen, Dr., 88690 Uhldingen-Mühlhofen (DE); WANG, Ning, Dipl.-Ing., 80809 München (DE); PIRINGER, Helmut, Dipl.-Ing., 85667 Oberpframmern (DE)
(74) Vertreter: Kopf Westenberger Wachenhausen Patentanwälte PartG mbB

(57) **Zusammenfassung**

Die vorliegende Erfindung betrifft eine Turbinenschaufel, umfassend ein vorgeformtes Fasergewebe aus Kohlenstoff-, Siliciumcarbid- oder Rheniumfasern, welches mit einem Bindemittelharz fixiert ist, und wobei das vorgeformte und fixierte Fasergewebe mit B₄C beschichtet bzw. infiltriert ist, wobei das vorgeformte, fixierte und mittels B₄C beschichtete bzw. infiltrierte Fasergewebe weiterhin eine mehrlagige Beschichtung aufweist aus mindestens einer Siliciumcarbidschicht und mindestens einer Schicht aus einem Metallborid, Metallnitrid oder Metallcarbid, und wobei über der mehrlagigen Beschichtung eine Oxidkeramik aufgebracht ist. Die Turbinenschaufel der vorliegenden Erfindung ist beständig gegen hohe Temperaturen und besonders zur Verwendung in einer Gasturbine geeignet. Ferner werden Verfahren zur Herstellung der erfindungsgemäßen Turbinenschaufel beschrieben.

## Beschreibung

Die vorliegende Erfindung betrifft eine Turbinenschaufel aus Oxidkeramik. Ferner betrifft die vorliegende Erfindung Verfahren zur Herstellung der erfindungsgemäßen Turbinenschaufel. Die Turbinenschaufel aus Oxidkeramik der vorliegenden Erfindung ist beständig gegen hohe Temperaturen und zur Verwendung in beispielsweise einer Gasturbine geeignet.

### Hintergrund der Erfindung

Der thermodynamische Wirkungsgrad von Gasturbinen (Joule-Brayton Kreisprozess) ist bestimmt durch die Bedingungen, insbesondere die Temperaturdifferenz, vor und nach dem Verdichter. Es können jedoch keine beliebig hohen Verdichtertemperaturen verwendet werden, da diese durch die anschließend erfolgende Verbrennung zu so hohen Temperaturwerten getrieben werden, dass die heute für Gasturbinen zur Verfügung stehenden Materialien selbst bei Verwendung einer Kühlung nicht mehr verwendbar sind. Typische maximal zulässige Temperaturen bei den heute für Gasturbinenschaufeln verwendeten Co-Basislegierungen liegen bei ca. 1175°C.

In der EP 0 863 221 sind Turbinenschaufeln aus einem Feingussmaterial mit hohem Chromanteil beschrieben. Die Turbinenschaufeln sollen eine verbesserte Temperaturbeständigkeit aufweisen.

Die DE 10 2004 011 151 beschreibt Turbinenschaufeln, deren Temperaturbeständigkeit mittels eines Kühlsystems verbessert werden soll.

Es besteht weiterhin Bedarf an Turbinenschaufeln, insbesondere für eine Gasturbine, die eine weiter verbesserte Temperaturbeständigkeit aufweisen.

In Stand der Technik sind Beschichtungen beschrieben, die die Temperaturbeständigkeit eines Materials erhöhen. Beispielsweise beschreibt die US 8,137,802 Beschichtungen mit sehr hoher Temperaturbeständigkeit (ultra high temperature - UHT). Diese Beschichtungen werden beispielsweise flächig auf die Oberfläche eines Raumfahrzeuges aufgebracht, um die Wiedereintrittstemperaturen überstehen zu können. Die Beschichtungen als solche weisen jedoch nicht die für Turbinenschaufeln erforderlichen mechanischen Eigenschaften, wie etwa Bruchfestigkeit auf.

Die US 8,409,491 beschreibt C-C- Kompositmaterialien mit einer UHT-Beschichtung. Diese Kompositmaterialien weißen zwar eine hohe Temperaturbeständigkeit auf, nicht jedoch die für eine Turbinenschaufel in einer Gasturbine erforderlichen mechanischen Eigenschaften, wie etwa Erosionsbeständigkeit gegen Gaseintritt bei hohen Geschwindigkeiten und Drücken.

Neben der erforderlichen verbesserten Temperaturbeständigkeit sollen Turbinenschaufeln die für den Einsatz in einer Gasturbine, wo beispielsweise Gas unter hohem Druck und hoher Geschwindigkeit einströmt, erforderliche mechanische Festigkeit, Bruchfestigkeit und Erosionsbeständigkeit aufweisen. Ebenso müssen solche Turbinen für den Einsatz in einer Gasturbine auch bei hohen Temperaturen oxidationsstabil sein. Aufgabe der vorliegenden Erfindung ist es derartige Turbinenschaufeln bereit zu stellen.

### Zusammenfassung der Erfindung

Die vorliegende Erfindung betrifft eine Turbinenschaufel, umfassend ein vorgeformtes Fasergewebe, d.h. einen gewebten 2D- und/oder 3D-Formkörper, aus Kohlenstoff-, Siliciumcarbidoder Rheniumfasern, welches mit einem Bindemittelharz fixiert ist, und wobei das vorgeformte und fixierte Fasergewebe mit B₄C beschichtet bzw. infiltriert ist, wobei das vorgeformte, fixierte und mittels B₄C beschichtete bzw. infiltrierte Fasergewebe weiterhin eine mehrlagige Beschichtung aufweist aus mindestens einer Siliciumcarbidschicht und mindestens einer Schicht aus einem Metallborid, Metallnitrid oder Metallcarbid, und wobei über der mehrlagigen Beschichtung eine Oxidkeramik aufgebracht ist.

Die Turbinenschaufel der vorliegenden Erfindung ist beständig gegen besonders hohe Temperaturen, wie etwa mehr als 2000°C, bis zu etwa 2500°C. Die Turbinenschaufel der Erfindung weist ferner die für Turbinenschaufeln erforderliche mechanische Festigkeit und Erosionsbeständigkeit auf.

Die vorliegenden Erfindung betrifft ferner die Verwendung der vorstehenden Turbinenschaufel in einer Gasturbine.

Ebenso betrifft die vorliegende Erfindung ein Verfahren zur Herstellung der Turbinenschaufel, umfassend die Schritte:
(a) Bereitstellen eines Fasergewebes, wobei das Fasergewebe ausgewählt ist aus Kohlenstoff-, Siliciumcarbid- und Rheniumfasern, und Vorformen und Fixieren des vorgeformten Fasergewebes mit einem Bindemittelharz;
(b) Beschichten bzw. Infiltrieren des vorgeformten und fixierten Fasergewebes mit B₄C;
(c) Aufbringen einer mehrlagigen Beschichtung auf das vorgeformte, fixierte und mit B₄C beschichtete bzw. infiltriere Fasergewebe, wobei die mehrlagige Beschichtung mindestens eine Siliciumcarbidschicht und mindestens eine Schicht aus einem Metallborid, Metallnitrid oder Metallcarbid aufweist; und
(d) Aufbringen einer Oxidkeramik auf die mehrlagige Beschichtung.

Weitere Ausführungsformen der vorliegenden Erfindung sind in der nachstehenden Beschreibung und in den beigefügten Ansprüchen beschrieben.

### Detaillierte Beschreibung der Erfindung

Zur Herstellung einer erfindungsgemäßen Turbinenschaufel wird zunächst ein Fasergewebe geeignet vorgeformt und fixiert. Dabei kommen temperaturbeständige Fasern zum Einsatz, insbesondere Kohlenstofffasern, Siliciumcarbidfasern oder Rheniumfasern. Vorformen und Fixieren des Fasergewebes erfolgt im Prinzip auf im Stand der Technik bekannte Weise. Zum Fixieren können im Stand der Technik bekannte und übliche Bindemittelharze verwendet werden, wie etwa ein Aminoharz, Polyurethanharz, Methacrylatharz, Phenol-Formaldehydharz, Vinylesterharz, Polyesterharz und Epoxidharz. Erfindungsgemäß wird ein Aminoharz bevorzugt, insbesondere ein Melamin-Formaldehydharz, wie etwa Cassurit, ein Melamin-Formaldehydharz von Clariant.

Das vorgeformte und fixierte Fasergewebe wird anschließend mit B₄C beschichtet bzw. infiltriert. Dazu kann im Prinzip jedes geeignet im Stand der Technik bekannte Beschichtungsverfahren eingesetzt werden, wie etwa beispielsweise das Wirbelschichtverfahren (FBR), chemische Gasphasenabscheidung (CVD), chemische Gasphaseninfiltation (CVI), oder elektrophoretische Infiltration. Erfindungsgemäß bevorzugt ist die Verwendung des Wirbelschichtverfahrens (FBR). Damit kann besonders gut gewährleistet werden, dass alle Zwischenräume des Fasergewebes geschlossen werden und das B₄C als homogene porenfreie Schicht aufgetragen wird und somit kein Sauerstoff zu den Fasern gelangen kann. Hierbei wird erfindungsgemäß vorzugsweise B₄C einer mittleren Korngröße im Bereich von 0,1 bis 20 µm eingesetzt. Die auf B₄C zurückgehende Gewichtszunahme beim Beschichten bzw. Infiltrieren des vorgeformten und fixierten Fasergewebes beträgt vorzugsweise etwa 5 Gew.% bis etwa 15 Gew.%, stärker bevorzugt etwa 10 Gew.%. Ein formgebendes Ober- bzw. Unterteil des Fasergewebes kann getrennt mit B₄C behandelt und anschließend zusammengesetzt werden. Nach dem Beschichten bzw. Infiltrieren mit B₄C kann eine thermische Behandlung durchgeführt werden, vorzugsweise bei etwa 2000°C.

Auf das vorgeformte, fixierte und mittels B₄C beschichtete bzw. infiltrierte Fasergewebe wird erfindungsgemäß weiterhin eine mehrlagige Beschichtung aufgebracht, um das Fasergewebe besser gegen das Eindringen von Sauerstoff und gegen hohe Temperaturen zu schützen. Die mehrlagige Beschichtung weist mindestens eine Siliciumcarbidschicht und mindestens eine Schicht aus einem Metallborid, Metallnitrid oder Metallcarbid auf. Vorzugsweise weisen die einzelnen Schichten der mehrlagigen Beschichtung eine Schichtdicke von 0,1 bis 30 µm auf. Die Reihenfolge dieser Schichten in der mehrlagigen Beschichtung ist zunächst nicht kritisch. Allerdings ist es erfindungsgemäß bevorzugt wenn die oberste Schicht der mehrlagigen Beschichtung eine Siliciumcarbidschicht, vorzugsweise mit einer Schichtdicke von 1-150 µm, ist.

Das Metallborid, Metallnitrid oder Metallcarbid für die entsprechende Schicht der mehrlagigen Beschichtung ist vorzugsweise ausgewählt aus HfB₂, HfC, HfN, ZrB₂, ZrC, ZrN, TiB₂, TiC, TiN, TaB₂, TaC, TaN, NbC, TaC und NdB₂. Erfindungsgemäß wird ZrB₂ und/oder HfB₂ besonders bevorzugt.

Verfahren zum Aufbringen der mehrlagigen Beschichtung sind erfindungsgemäß nicht besonders beschränkt. Im Prinzip kommen alle im Stand der Technik bekannten geeigneten Verfahren in Frage, wie beispielsweise ein Wirbelschichtverfahren (FBR), chemischer Gasphasenabscheidung (CVD), Liquid Silicon Infiltration (LSI), Pyrolyse (LPI), chemischer Gasphaseninfiltration (CVI), oder elektrophoretische Infiltration. Erfindungsgemäß ist das Aufbringen der mehrlagigen Beschichtung mittels chemischer Gasphasenabscheidung (CVD) bevorzugt.

Gemäß der vorliegenden Erfindung wird weiterhin eine Oxidkeramik auf die mehrlagige Beschichtung aufgebracht. Durch die Kombination der erfindungsgemäßen Maßnahmen wird nicht nur eine Turbinenschaufel hoher Temperaturbeständigkeit, Oxidationsstabilität und Bruchfestigkeit erreicht, sondern auch eine hohe mechanische Festigkeit und Erosionsbeständigkeit, wie sie zum Einsatz in Gasturbinen erforderlich ist.

Dazu werden erfindungsgemäß keramische Werkstoffe mit hohem Schmelzpunkt, insbesondere einem Schmelzpunkt von mehr als 2000°C ausgewählt. Vorzugsweise werden für das keramische Material der Oxidkeramik Oxide verwendet, ausgewählt aus Al₂O₃, ZrO₂, MgO, Y₂O₃ und HfO₂ oder Gemischen davon. Oxide mit höherem Schmelzpunkt sind dabei bevorzugt. Demgemäß werden erfindungsgemäß vorzugsweise Oxide, ausgewählt aus ZrO₂, MgO, Y₂O₃ und HfO₂ oder Gemischen davon, stärker bevorzugt. Besonders bevorzugt ist erfindungsgemäß die Verwendung von ZrO₂.

Das Verfahren zum Aufbringen der Oxidkeramik auf das erfindungsgemäß vorbehandelte Fasergewebe ist nach der vorliegenden Erfindung nicht besonders beschränkt. Im Prinzip kommt jedes im Stand der Technik bekannte geeignete Verfahren in Frage. Typischerweise wird zunächst ein Schlicker aufbereitet durch Plastifizieren eines Pulvers des oxidischen keramischen Werkstoff in Wasser oder einem organischen Lösungsmittel sowie Vermischen und Homogenisieren der erhaltenen Masse. Gegebenenfalls erfolgt danach auch eine Teilentwässerung. Die erhaltene Masse kann auf das erfindungsgemäß vorbehandelte Fasergewebe beispielsweise durch Spritzgießen aufgebracht werden, in einer Gießform, die das erfindungsgemäß vorbehandelte Fasergewebe als Einlegekern enthält. Die Gießformen bestehen typischerweise aus porösem Kunststoff mit einer Porengröße im Bereich von 12-22 µm und einer Wasserdurchlässigkeit von 10-28 l/min. Derartige Kunststoffe sind im Handel erhältlich, beispielsweise unter dem Handelsnamen Castimo-Resin. Alternativ kann ein gesinterter offenporiger Metallschaum, z.B. Aluminiumschaum, für die Gießform verwendet werden.

Anschließend wird der spritzgegossene Rohling getrocknet, wobei ein Grünling erhalten wird. Der Grünling kann aus der Gießform entfernt und gegebenenfalls mechanisch bearbeitet werden. Der gegebenenfalls mechanisch bearbeitete Grünling wird anschließend gesintert. Die Sintertemperatur beträgt typischerweise 70-80% der Schmelztemperatur des keramischen Oxids, z.B. je nach Oxid 1200°C-2200°C. Die erhaltene gehärtete Keramik kann gegebenenfalls ebenfalls nachbearbeitet werden.

Dabei wird eine Turbinenschaufel erhalten, die neben hoher Temperaturbeständigkeit auch hohe Oxidationsbeständigkeit, Bruchfestigkeit, und die für die Verwendung in Gasturbinen erforderliche mechanische Festigkeit und Erosionsstabilität aufweist. Die Turbinenschaufel der vorliegenden Erfindung kann daher vorteilhaft in Gasturbinen eingesetzt werden, wobei höhere Verdichtertemperaturen als derzeit im Stand der Technik erreichbar, möglich sind. Beispielsweise kann eine Turbinenschaufel der vorliegenden Erfindung bei Verdichtertemperaturen von 2000°C oder mehr, vorzugsweise bei bis zu 2500°C, eingesetzt werden. Damit sind Gasturbinen mit einem verbesserten thermodynamischen Wirkungsgrad möglich.

## Patentansprüche

1. Turbinenschaufel, umfassend ein vorgeformtes Fasergewebe aus Kohlenstoff-, Siliciumcarbid- oder Rheniumfasern, welches mit einem Bindemittelharz fixiert ist, und wobei das vorgeformte und fixierte Fasergewebe mit B₄C beschichtet bzw. infiltriert ist, wobei das vorgeformte, fixierte und mittels B₄C beschichtete bzw. infiltrierte Fasergewebe weiterhin eine mehrlagige Beschichtung aufweist aus mindestens einer Siliciumcarbidschicht und mindestens einer Schicht aus einem Metallborid, Metallnitrid oder Metallcarbid, und wobei über der mehrlagigen Beschichtung eine Oxidkeramik aufgebracht ist.

2. Turbinenschaufel gemäß Anspruch 1, wobei die Oxidkeramik besteht aus einem Oxid, ausgewählt aus Al₂O₃, ZrO₂, MgO, Y₂O₃ und HfO₂, vorzugsweise ausgewählt aus ZrO₂, MgO, Y₂O₃ und HfO₂, stärker bevorzugt ZrO₂.

3. Turbinenschaufel gemäß Anspruch 1 oder 2, wobei das Metallborid, Metallnitrid oder Metallcarbid ausgewählt ist aus HfB₂, HfC, HfN, ZrB₂, ZrC, ZrN, TiB₂, TiC, TiN, TaB₂, TaC, TaN, NbC, TaC und NdB₂, vorzugsweise aus ZrB₂ und HfB₂.

4. Verwendung einer Turbinenschaufel nach einem der Ansprüche 1-3 in einer Gasturbine.

5. Verfahren zur Herstellung einer Turbinenschaufel, umfassend die Schritte:
(a) Bereitstellen eines Fasergewebes, wobei das Fasergewebe ausgewählt ist aus Kohlenstoff-, Siliciumcarbid- und Rheniumfasern, und Vorformen und Fixieren des vorgeformten Fasergewebes mit einem Bindemittelharz;
(b) Beschichten bzw. Infiltrieren des vorgeformten und fixierten Fasergewebes mit B₄C;
(c) Aufbringen einer mehrlagigen Beschichtung auf das vorgeformte, fixierte und mit B₄C beschichtete bzw. infiltriere Fasergewebe, wobei die mehrlagige Beschichtung mindestens eine Siliciumcarbidschicht und mindestens eine Schicht aus einem Metallborid, Metallnitrid oder Metallcarbid aufweist; und
(d) Aufbringen einer Oxidkeramik auf die mehrlagige Beschichtung.

6. Verfahren gemäß Anspruch 5, wobei das Bindemittelharz ausgewählt ist aus einem Aminoharz, Polyurethanharz, Methacrylatharz, Phenol-Formaldehydharz, Vinylesterharz, Polyesterharz und Epoxidharz, vorzugsweise aus einem Aminoharz, stärker bevorzugt aus einem Melamin-Formaldehydharz.

7. Verfahren gemäß Anspruch 5 und 6, wobei das Beschichten bzw. Infiltrieren mit B₄C durchgeführt wird mittels Wirbelschichtverfahren (FBR), chemischer Gasphasenabscheidung (CVD), chemischer Gasphaseninfiltation (CVI), oder elektrophoretischer Infiltration, bevorzugt mittels Wirbelschichtverfahren (FBR), und wobei das B₄C vorzugsweise eine Korngröße im Bereich von 0,1 bis 20 µm aufweist, und wobei beim Beschichten bzw. Infiltrieren eine auf B₄C zurückgehende Gewichtszunahme des vorgeformten und fixierten Fasergewebes von vorzugsweise 5 Gew.% bis 15 Gew.%, stärker bevorzugt etwa 10 Gew.% erreicht wird.

8. Verfahren gemäß einem der Ansprüche 5-7, wobei das Metallborid, Metallnitrid oder Metallcarbid der mehrlagigen Beschichtung ausgewählt ist aus HfB₂, HfC, HfN, ZrB₂, ZrC, ZrN, TiB₂, TiC, TiN, TaB₂, TaC, TaN, NbC, TaC und NdB₂, vorzugsweise aus ZrB₂ und HfB₂.

9. Verfahren gemäß einem der Ansprüche 5-8, wobei die mehrlagige Beschichtung aufgebracht wird mittels Wirbelschichtverfahren (FBR), chemischer Gasphasenabscheidung (CVD), Liquid Silicon Infiltration (LSI), Pyrolyse (LPI), chemischer Gasphaseninfiltration (CVI), oder elektrophoretischer Infiltration, vorzugsweise mittels chemischer Gasphasenabscheidung (CVD).

10. Verfahren gemäß einem der Ansprüche 5-9, wobei die einzelnen Schichten der mehrlagigen Beschichtung eine Schichtdicke von 0,1 bis 30 µm aufweisen.

11. Verfahren gemäß einem der Ansprüche 5-10, wobei auf die mehrlagige Beschichtung eine oberste Siliciumcarbidschicht aufgebracht wird, vorzugsweise mit einer Schichtdicke von 1-150 µm.

12. Verfahren gemäß einem der Ansprüche 5-11, wobei die Oxidkeramik besteht aus einem Oxid, ausgewählt aus Al₂O₃, ZrO₂, MgO, Y₂O₃ und HfO₂, vorzugsweise ausgewählt aus ZrO₂, MgO, Y₂O₃ und HfO₂, stärker bevorzugt ZrO₂.

13. Verfahren gemäß einem der Ansprüche 5-12, wobei die Oxidkeramik aufgebracht wird durch Plastifizieren eines Pulvers eines oxidischen keramischen Werkstoff in Wasser oder einem organischen Lösungsmittel, Vermischen und Homogenisieren der erhaltenen Masse, Aufbringen der Masse auf die mehrlagige Beschichtung des vorgeformten und fixierten Fasergewebes durch Spritzgießen in einer Gießform, Trocknen des erhaltenen Rohlings und Sintern des getrockneten Rohlings nach dem Entfernen aus der Gießform.
